# EUROPÄISCHE PATENTSCHRIFT

(11) **EP 2 467 447 B1**
(45) Veröffentlichungstag und Bekanntmachung des Hinweises auf die Patenterteilung: **03.01.2018**
(21) Anmeldenummer: 10747437.1
(22) Anmeldetag: 11.08.2010
(51) Int. Cl.: H01L 33/50, C09K 11/59, C09K 11/80

(54) **KONVERSIONS-LED MIT HOHER EFFIZIENZ**
HIGH EFFICIENCY CONVERSION LED
DEL À CONVERSION DE HAUTE EFFICACITÉ

(30) Priorität: 17.08.2009 DE 102009037732
(43) Veröffentlichungstag der Anmeldung: 27.06.2012
(60) Teilanmeldung: 17202596.7
(73) Patentinhaber: OSRAM Opto Semiconductors GmbH, 93055 Regensburg (DE)
(72) Erfinder: BAUMANN, Frank, 93055 Regensburg (DE); BOENISCH, Norbert, 81541 München (DE); FIEDLER, Tim, 81369 München (DE); JERMANN, Frank, 86343 Königsbrunn (DE); LANGE, Stefan, 86157 Augsburg (DE); WINDISCH, Reiner, 93186 Pettendorf (DE)
(74) Vertreter: Epping - Hermann - Fischer
(86) Internationale Anmeldenummer: PCT/EP2010/061674
(87) Internationale Veröffentlichungsnummer: WO 2011/020751

(56) Entgegenhaltungen:
- EP-A2- 1 669 429
- US-B2- 6 649 946
- US-B2- 7 297 293
- J.L.WU,S.P.DENBAARS,V.SRDANOV,H.WEINBERG: "Spectral properties of Various Cerium Doped Garnet Phosphors for Application in White GaN-based LEDs", MAT.RES.SOC.SYMP.PROC., vol. 658, 2001, pages GG11.8.1-GG11.8.6,
- J.L.WU,S.P.DENBAARS,V.SRDANOV,H.WEINBERG: "Cerium Doped Garnet Phosphors for Application in White GaN-based LEDs", MAT.RES.SOC.SYMP.PROC., vol. 667, 2001, pages G5.1.1-G5.1.6,

## Beschreibung

### Technisches Gebiet

Die Erfindung geht aus von einer Konversions-LED gemäß dem Oberbegriff des Anspruchs 1. Derartige Konversions-LEDs sind insbesondere für Allgemeinbeleuchtung geeignet.

### Stand der Technik

Aus der US 6 649 946 ist eine Konversions-LED bekannt, die zur Erzielung einer weißen LED einen blauen Chip zusammen mit Sr2Si5N8:Eu verwendet, wobei als zusätzlicher Leuchtstoff zur Verbesserung der Farbwiedergabe auch YAG:Ce verwendet wird. Damit lassen sich jedoch nur wenig effiziente LED realisieren.

Aus der US-B 7 297 293 ist eine Konversions-LED bekannt, die zur Erzielung einer weißen LED einen blauen Chip zusammen mit (Sr,Ca)2Si5N8:Eu verwendet, wobei als zusätzlicher Leuchtstoff zur Verbesserung der Farbwiedergabe auch YAG:Ce sowie ähnliche Leuchtstoffe mit teilweisem Ersatz des Y durch Gd bzw. teilweisem Ersatz des Al durch Ga verwendet wird. Damit lassen sich jedoch nur wenig effiziente LED realisieren.

Aus der EP-A 1 669 429 ist eine Konversions-LED bekannt, die zur Erzielung einer weißen LED einen blauen Chip zusammen mit speziellem Leuchtstoff des Typs (Sr,Ba)2Si5N8:Eu verwendet, wobei als zusätzlicher Leuchtstoff zur Verbesserung der Farbwiedergabe auch Lu-AG:Ce sowie ähnliche Leuchtstoffe, die mit Ce und Pr kodotiert sind, verwendet werden.

### Darstellung der Erfindung

Die Aufgabe der vorliegenden Erfindung ist es, eine Konversions-LED bereitzustellen, die mit hoher Effizienz ausgestattet ist, wobei die Konversions-LED insbesondere eine hohe nutzbare Lebensdauer erreicht.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt eine Konversions-LED hoher Effizienz bereitgestellt. Nicht alle Leuchtstoffe sind in bei hohen Strömen, hier insbesondere mindestens 250 mA, bevorzugt mindestens 300 mA, besonders bevorzugt mindestens 350 mA, betriebenen LEDs, sog. Hochleistungs-LED, stabil. Insbesondere gilt diese Problematik für nitridische oder oxinitridische Leuchtstoffe wie das Nitridosilikat M2Si5N8:Eu. Viele derartige Leuchtstoffe, insbesondere Nitride des Typs M2Si5N8:D mit D als Aktivator erleiden beim Betrieb in einer LED deutliche Konversionsverluste. Beim Belastungstest mit bis zu 700 mA Dauerstrom verlieren weiße LEDs mit derartigen Leuchtstoffen in kurzer Zeit (typisch 1000 Std.) bis zu 50% Konversionseffizienz. Dies führt zu einer ausgeprägten Instabilität des Farborts.

Weiße LEDs gewinnen in der Allgemeinbeleuchtung immer mehr an Bedeutung. Insbesondere steigt die Nachfrage nach warmweißen LEDs mit niedrigen Farbtemperaturen, bevorzugt im Bereich 2900 bis 3500 K, insbesondere 2900 bis 3100 K, und guter Farbwiedergabe, insbesondere Ra ist mindestens 93, bevorzugt mindestens 96, und gleichzeitig hoher Effizienz. Erreicht werden diese Ziele in der Regel durch die Kombination einer blauen LED mit gelben und roten Leuchtstoffen. Die Spektren all dieser Lösungen weisen eine Region im blau-grünen Spektralbereich auf, in der sehr wenig Strahlung emittiert wird (Blau-Grün-Lücke), dadurch ergibt sich eine mangelhafte Farbwiedergabe. Zur Kompensation werden in der Regel sehr langwellige blaue LEDs eingesetzt (ca. 460nm). Seitens der Chiptechnologie ist es jedoch vorteilhaft, LEDs kürzerer Chipwellenlängen einzusetzen, da diese deutlich effizienter sind. Gewünscht sind Wellenlängen (Peak) von 430 bis 455 nm, insbesondere 435 bis 445 nm.

Wird der blau-grüne Anteil des Gesamtspektrums im Wesentlichen alleine durch die blaue LED bestimmt, wie dies bei den bisherigen Kombinationen aus langwelliger blauer LED und gelbem sowie rotem Leuchtstoff der Fall ist, so ergibt sich eine starke Abhängigkeit des Gesamt-CRI der weißen LED von der eingesetzten Chipwellenlänge. Aus technischen Gründen muss jedoch in der Praxis immer ein relativ breiter Bereich von Chipwellenlängen in einem Produkt verwendet werden, so dass große Schwankungen im CRI die Folge sind. Weiterhin müssen die Leuchtstoffe eine sehr hohe Stabilität gegenüber chemischen Einflüssen, beispielsweise Sauerstoff, Feuchtigkeit, Wechselwirkungen mit Vergussmaterialien, sowie gegenüber Strahlung aufweisen. Um einen stabilen Farbort bei steigender Systemtemperatur zu gewährleisten, sind außerdem Leuchtstoffe erforderlich, die ein sehr geringes Temperaturlöschverhalten aufweisen.

Die bisherigen effizientesten Warmweiß-Lösungen basieren auf der Kombination eines gelben Granatleuchtstoffs wie YAG:Ce oder YAGaG:Ce, der Al und Ga gleichzeitig enthält, und einem Nitridosilikat wie (Ba,Sr,Ca)₂Si₅N₈:Eu. Um eine hinreichend gute Farbwiedergabe zu erreichen, ist hier der Einsatz sehr langwelliger blauer LEDs (etwa 455 bis 465 nm) nötig, wodurch aber die Systemeffizienz deutlich eingeschränkt wird. Bei Verwendung kürzerer Chipwellenlängen von 430 bis 450 nm, vorteilhaft bis 445 nm, mit den bisherigen Leuchtstoffen ist aber die Farbwiedergabe mangelhaft, insbesondere im blau-grünen Spektralbereich. Weiterhin ergeben sich durch die starke Abhängigkeit des CRI von der Blau-Wellenlänge signifikante Schwankungen des CRI innerhalb des Produkts. Die Stabilität der bisherigen Lösung in der LED ist gerade noch ausreichend. Bei hohen Strömen, hier insbesondere mindestens 250 mA, bevorzugt mindestens 300 mA, besonders bevorzugt mindestens 350 mA, ist sie kritisch, da die thermische Belastung immer mehr steigt.

Die neue Lösung besteht aus der Kombination aus einem grün bis grün-gelb emittierenden Granatleuchtstoff und einem kurzwelligen, schmalbandigen orange-rot emittierenden Nitridosilikat-Leuchtstoff. Der grüne Granatleuchtstoff zeigt gegenüber den bisher eingesetzten gelben (YAG) bzw. grüngelben (YAGaG) Granaten eine stark grünverschobene Emission, gleichzeitig ist das Anregungsoptimum stark kurzwellig verschoben. Diese Grünverschiebung des Granats führt zu einer deutlichen Verkleinerung der Blau-Grün-Lücke im Weißspektrum.

Aufgrund dieser Eigenschaften können deutlich kurzwelligere LEDs (ca. 435 nm bis 445 nm Peakwellenlänge statt 455 nm in der bisherigen Lösung) eingesetzt werden und gleichzeitig weiterhin ein CRI der weißen LED von größer 80 erreicht werden. Durch die speziellen spektralen Eigenschaften der neu entwickelten Leuchtstoff-Mischung bleibt zudem der CRI über einen weiten Bereich blauer LED-Wellenlängen annähernd konstant, wodurch eine gleichmäßige Farbqualität innerhalb eines "LED-Bins" gewährleistet wird. Weiterhin zeichnet sich die neu entwickelte Kombination dieser Leuchtstoffe durch eine sehr hohe chemische und photochemische Stabilität sowie eine sehr geringes Temperaturlöschverhalten aus.

Der entscheidende Fortschritt besteht jetzt darin, dass eine gleichzeitige Verbesserung mehrerer aus Applikationssicht zentraler Eigenschaften erreicht wurde, nämlich in Bezug auf Alterungsstabilität, Effizienz, verwendbarer Chipwellenlängenbereich und Temperaturstabilität der Leuchtstoffe. Der Unterschied dieser neuen Lösung gegenüber vorbekannten Warmweiß-Lösungen mit niedrigen Farbtemperaturen, bevorzugt im Bereich 2900 bis 3500 K, insbesondere 2900 bis 3100 K ist:
- Sehr stark grünverschobener Granatleuchtstoff. Dies bringt Vorteile bei: CRI, Augenbewertung, Temperaturstabilität; λ_{dom} sollte bevorzugt bei 552-559 nm liegen, die FWHM sollte bevorzugt bei 105- 113 nm liegen (bezogen auf Anregung bei 435 nm).
- Sehr kurze Chipwellenlänge von 430 bis 450 nm Peak-Wellenlänge. Dies bringt einen großen Vorteil im Hinblick auf hohe Effizienz;
- Kurzwellig emittierender und schmalbandiger Rotleuchtstoff; λ_{dom} sollte bevorzugt bei 596-604 nm liegen, die FWHM sollte bevorzugt kleiner 100nm, besonders bevorzugt kleiner 90 nm liegen (bezogen auf Anregung bei 435 nm). Dies bringt Vorteile bei: Lebensdauer der LED, Augenbewertung.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: einen Vergleich der Temperaturabhängigkeit verschiedener grün emittierender Leuchtstoffe;
- Fig. 3: einen Vergleich der Temperaturabhängigkeit verschiedener rot emittierender Leuchtstoffe;
- Fig. 4: einen Vergleich des Effizienzverlusts von Nitridosilikaten für verschiedene Dotiergehalte an Eu als Funktion des Ba-Anteils;
- Fig. 5: einen Vergleich des Effizienzverlusts von Nitridosilikaten unter verschiedenem Belastungsszenario als Funktion des Ba-Anteils;
- Figur 6: einen Vergleich des Konverterverlusts vor und nach Belastung für verschiedene Leuchtstoffe;
- Figur 7: einen Vergleich der Zeitabhängigkeit der Konverter-Verluste für verschiedene Leuchtstoffe;
- Fig. 8: einen Vergleich des CRI für verschiedene Leuchtstoffmischungen bei Wellenlängenverschiebung der Primäranregung;
- Fig. 9: einen Vergleich der Gesamtemission einer Konversions-LED bei verschiedener Primäremission;
- Fig. 10-12: einen Vergleich der Emission von LuAGaG bzw. YAGaG bzw. Misch-Sion bei verschiedener Peaklage der Primäremission (Ex);
- Fig. 13: ein LED-Modul mit entfernt angebrachter Leuchtstoffmischung;
- Fig. 14: einen Vergleich der Emission bei Lu-Granaten, die verschiedenen Gehalt an Y enthalten.

### Bevorzugte Ausführungsform der Erfindung

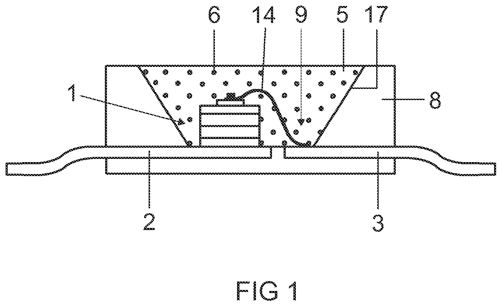

Figur 1 zeigt den Aufbau einer Konversions-LED für weißes Licht auf RGB-Basis wie an sich bekannt. Die Lichtquelle ist ein Halbleiterbauelement mit einem blau emittierende Chip 1 des Typs InGaN in Hochstromausführung mit 350 mA Betriebsstrom. Er hat eine Peakemissionswellenlänge von 430 bis 450 nm Peakwellenlänge, beispielsweise 435 nm, und ist in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (70 bis 95 Gew.-%) und Leuchtstoffpigmente 6 (weniger als 30 Gew.-%) enthält. Ein erster Leuchtstoff ist ein grün emittierendes LuAGaG:Ce, ein zweiter **Leuchtstoff** ist ein rot emittierendes Nitridosilikat SrBaSi5N8:Eu. Die Ausnehmung hat eine Wand 17, die als Reflektor für die Primär- und Sekundärstrahlung vom Chip 1 bzw. den Pigmenten 6 dient.

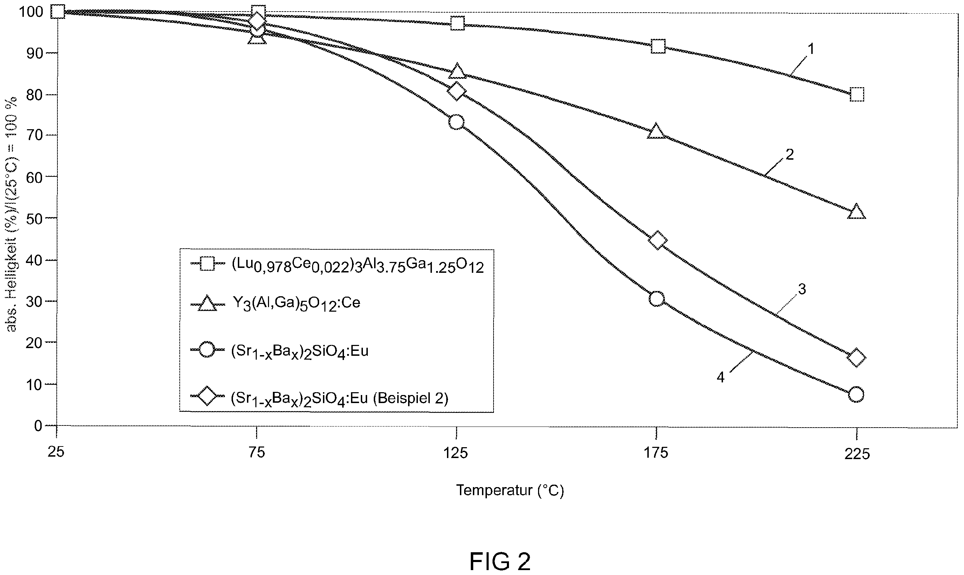

Figur 2 zeigt das Temperaturlöschungs-Verhalten verschiedener gelb-grün emittierender Leuchtstoff, die sich im Prinzip gut mit dem Chip aus Figur 1 anregen lassen. Der Leuchtstoff A3B5012:Ce, wobei A=überwiegend Lu, in der Ausführungsform mit der bevorzugten Zusammensetzung LuAGaG, also Lu3(Al,Ga)5O12:Ce mit ca. 25% Anteil Ga für Komponente B (bevorzugt sind 10-40% Ga-Anteil, besonders bevorzugt sind 15-30% Ga-Anteil) und ca. 2,2% Ce (bevorzugt sind 1.5-2.9% Ce, besonders bevorzugt 1.8-2.6% Ce, jeweils bezogen auf den Anteil A), zeichnet sich durch sehr geringe Temperaturlöschung aus. Ein bevorzugter Leuchtstoff ist (Lu0.978Ce0.022)3Al3.75Ga1.25O12, siehe Kurve 1. Die Grafik zeigt einen Vergleich mit anderen gelben und grünen Leuchtstoffen, die ein wesentlich schlechteres Temperaturlöschungs-Verhalten zeigen. Orthosilikate (Kurve 3,4) sind völlig ungeeignet, aber auch YAGaG (Kurve 2) ist unbrauchbar.

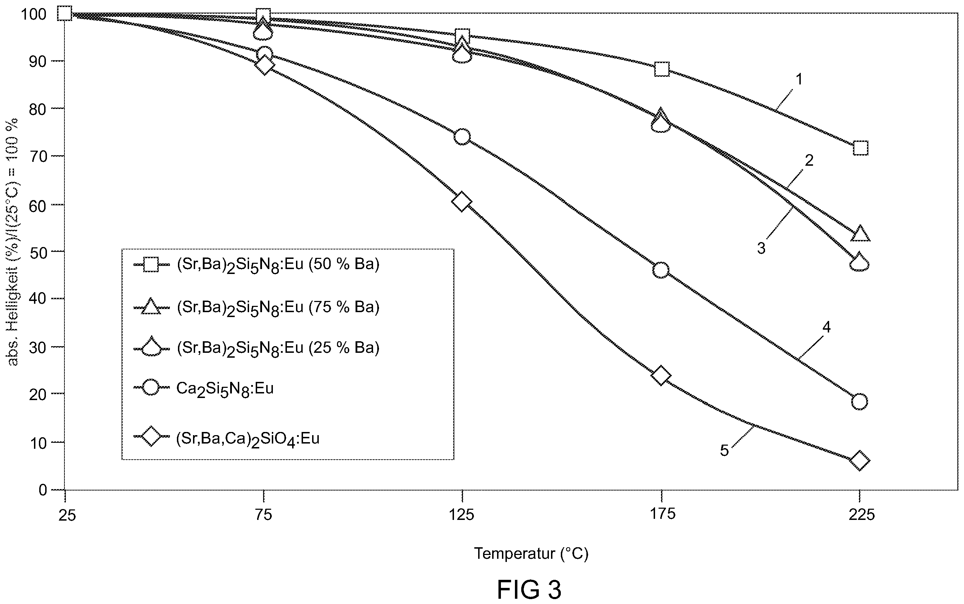

Figur 3 zeigt das Temperaturlöschungs-Verhalten verschiedener orange-rot emittierender Leuchtstoff, die sich im Prinzip gut mit dem Chip aus Figur 1 anregen lassen. Der neue Leuchtstoff vom Typ Nitridosilikat M2Si5N8:Eu mit der bevorzugten Zusammensetzung (Sr,Ba)2Si5N8:Eu mit ca. 50% Ba ((x = 0.5); allgemein ist bevorzugt x = 0.35-0.75, besonders bevorzugt x = 0.4-0.6) und ca. 4% Eu ((y =0.04); allgemein ist bevorzugt ein Eu-Anteil an M von x = 0.01-0.20, besonders bevorzugt x = 0.02-0.06), zeichnet sich durch sehr geringe Temperaturlöschung aus. Gut geeignet ist ein Nitridosilikat mit x = 0.4-0.6 vom Typ Sr_{1-x-y/2}Ba_{x-y/2E}u_{y}) ₂Si₅N₈, siehe Kurve 1. Die Grafik zeigt einen Vergleich mit anderen orange/roten Leuchtstoffen. Deutlich schlechter geeignet sind Nitridosilikate mit x= 0,25 oder x=0,75, siehe Kurve 2 und 3. Ungeeignet sind Ca-Nitridosilikate (Kurve 4) und Orthosilikate (Kurve 5).

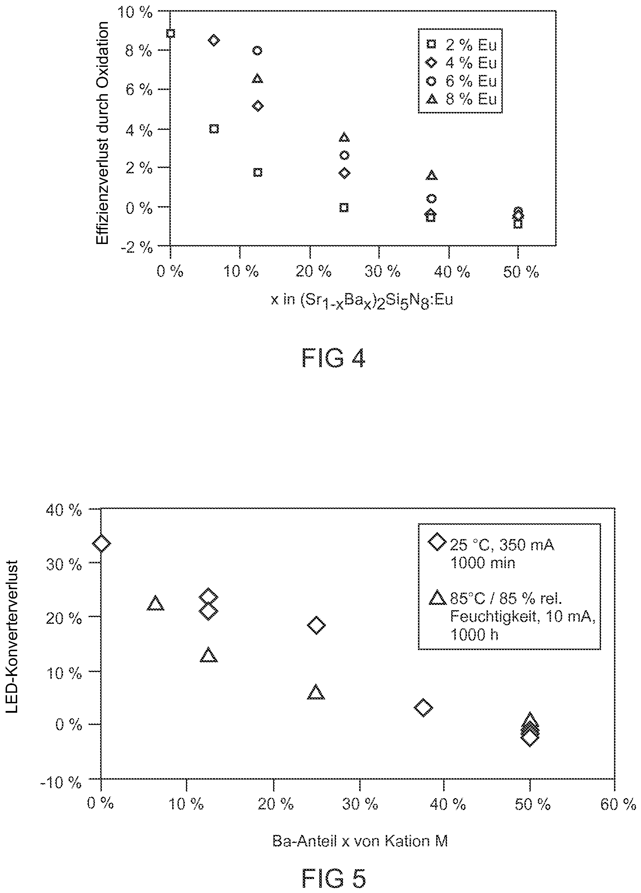

Figur 4 zeigt das Ergebnis eines Oxidations-Stabilitätstests. Dabei wurde die Stabilität des Systems (Sr,Ba)2Si5N8:Eu mit variablem Ba-Gehalt ermittelt. Dazu wurde die Probe zunächst charakterisiert, anschließend 68h bei 150°C an Luft ausgeheizt und anschließend nochmals charakterisiert. Die Differenz beider Effizienzen zu unterschiedlichen Zeitpunkten gibt den Effizienzverlust an. Die besten Leuchtstoffe sind im Rahmen der Messfehler perfekt stabil. Bevorzugt ist dabei der Leuchtstoff mit ca. 45 bis 53% Ba bei ca. 4% Eu-Anteil von M, insbesondere der Leuchtstoff (Sr0, 48Ba0.48Eu0,04)2Si5N8.

Figur 5 zeigt das Ergebnis eines LED-Alterungstests. Dabei wurde die Stabilität des Systems (Sr,Ba)2Si5N8:Eu mit variablem Ba-Gehalt x ermittelt. Dabei wurde eine blaue Hochleistungs-LED (λₚₑₐₖ bei etwa 435 nm) mit einer Dispersion des jeweiligen Leuchtstoffs in Silikon vergossen und diese bei 350 mA für 1000 min betrieben. Die relativen Intensitäten des blauen LED-Peaks der Primäremission sowie des Leuchtstoffpeaks wurden zum Beginn und zum Ende des Tests gemessen und daraus der Verlust der Konversionseffizienz relativ zur Intensität des blauen LED-Peaks bestimmt. Man erkennt in Figur 5 (viereckige Messpunkte) eine eindeutige Zunahme der Stabilität mit steigendem Barium-Gehalt. Der als optimal sich erweisende Leuchtstoff mit ca. 50% Ba und ca. 4% Eu ((Sr0, 48Ba0.48Eu0, 04)2Si5N8, L358) ist im Rahmen der Messfehler perfekt stabil. In einem weiteren Test (1000h, 10mA, 85% rel. Luftfeuchtigkeit, 85°C) zeigt sich die gleiche Tendenz (dreieckige Messpunkte).

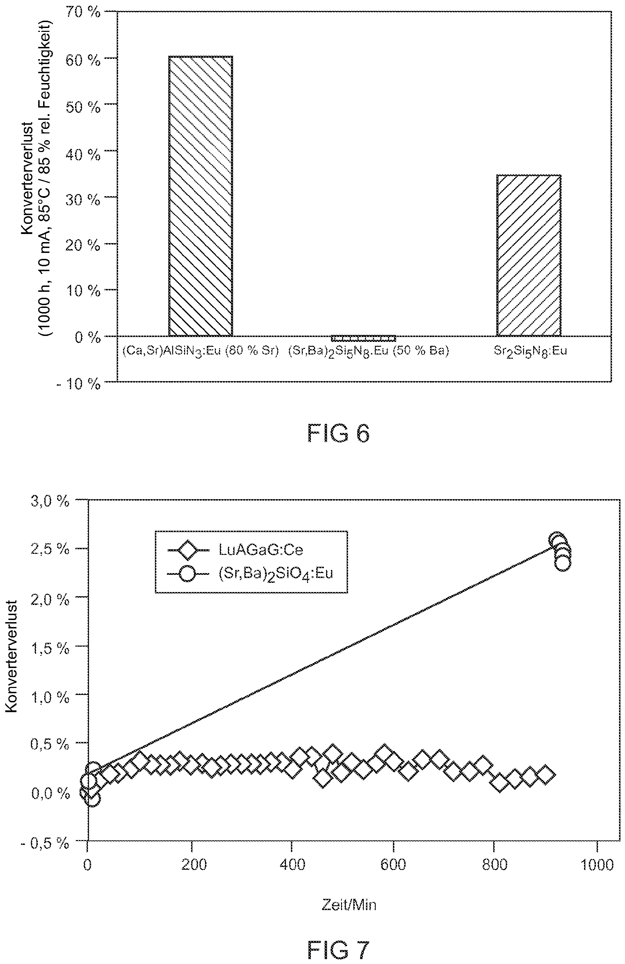

Figur 6 zeigt den Vergleich dreier Rot-Leuchtstoff-Systeme mit schmalbandiger Emission mit λ_{dom} < 605 nm in einem LED-Alterungstest (1000h, 10mA, 85% rel. Luftfeuchtigkeit, 85°C): die erste Säule bezieht sich auf ein Calsin mit Sr-Anteil, die zweite Säule ist der erfindungsgemäß beste Leuchtstoff, ein gemischtes Nitridosilikat mit gleichen Anteilen Sr und Ba, die dritte Säule zeigt das Verhalten des reinen Sr-Nitridosilikats. Das gemischte Nitridosilikat ist im Rahmen der Messfehler perfekt stabil, während die Vergleichssysteme sehr stark altern.

Figur 7 zeigt die Stabilität der gelb-grün-Komponente. In einem LED-Alterungstest wurde die Stabilität des neuen Grünleuchtstoffs mit der bevorzugten Zusammensetzung (LuAGaG mit ca. 25% Ga und ca. 2,2% Ce, (Lu0.978Ce0.022)3Al3.75Gal.25O12) ermittelt und mit anderen bekannten gelb/grünen Leuchtstoffen verglichen. Dabei wurde eine blaue Hochleistungs-LED (λₚₑₐₖ=435 nm) mit einer Dispersion des jeweiligen Leuchtstoffs in Silikon vergossen und diese bei 350 mA für 1000 h betrieben. Die relativen Intensitäten des blauen LED-Peaks sowie des Leuchtstoffpeaks wurden zum Beginn und zum Ende gemessen und daraus der Verlust der Konversionseffizienz bestimmt. Der neue LuAGaG-Leuchtstoff ist im Rahmen der Messfehler perfekt stabil (viereckige Messpunkte) während ein Orthosilikat unter vergleichbaren Bedingungen deutliche Alterungserscheinungen zeigt (runde Messpunkte).

Die Farbwiedergabe der warmweißen LED mit der erfindungsgemäßen neuen Leuchtstoffmischung gelb-grün mit orange-rot ist praktisch unabhängig von der eingesetzten LED-Wellenlänge. Eine Verschiebung der Blau-Wellenlänge um 9 nm bewirkt nur einen CRI-Verlust von 1 Punkt. Das Gegenbeispiel der bisherigen Mischung verliert bereits bei einem Unterschied von 7 nm Blau-Wellenlänge 5 Punkte (siehe Tabelle 1). Um den CRI-Verlust auf 1 Punkt zu verringern, ist die Zugabe eines dritten Leuchtstoffs nötig, was die Effizienz und das Colour-Steering negativ beeinflusst.

**Tab. 1: hier bedeutet CRI den Farbwiedergabeindex**

| Muster | Peak-Wellenlänge der blauen LED / nm | Farbtemperatur / K | Leuchtstoff 1 (grün-gelb) | Leuchtstoff 2 (orange-rot) | Leuchtstoff 3 (blaugrün) | Verhältnis gelb:rot | CRI Ra8 |
|---|---|---|---|---|---|---|---|
| 1 | 444 | 3000 | LuAGaG:2.2 %Ce (25%Ga) | (Sr,Ba)2Si5N8:Eu (50% Ba) | - | 9.3:1 | 83 |
| 2 | 435 | 3050 | LuAGaG:2.2 %Ce (25%Ga) | (Sr,Ba)2Si5N8:Eu (50% Ba) | - | 8.9:1 | 82 |
| | | | | | | | |
| VGL1 | 462 | 3200 | YAG:3%Ce | (Sr, Ca) 2Si5N8:Eu (60% Sr) | - | 9:1 | 81 |
| VGL2 | 455 | 3250 | YAG:3%Ce | (Sr,Ca) 2Si5N8:Eu (60% Sr) | - | 10.3:1 | 76 |
| VGL3 | 455 | 3200 | YAG:3%Ce | (Sr,Ca) 2Si5N8:Eu (60% Sr) | grünes Chlorosilikat | 9:1 | 80 |
| | | | | | | | |
| VGL4 | 462 | 3250 | YAGaG:4%Ce (25%Ga) | (Sr,Ca) 2Si5N8:Eu (60% Sr) | - | 6.1:1 | 86 |
| VGL5 | 455 | 3250 | YAGaG:4%Ce (25%Ga) | (Sr,Ca) 2Si5N8:Eu (60% Sr) | - | 7:1 | 83 |
| VGL6 | 444 | 3200 | YAGaG:4%Ce (25%Ga) | (Sr,Ca) 2Si5N8:Eu (60% Sr) | - | 7:1 | 77 |

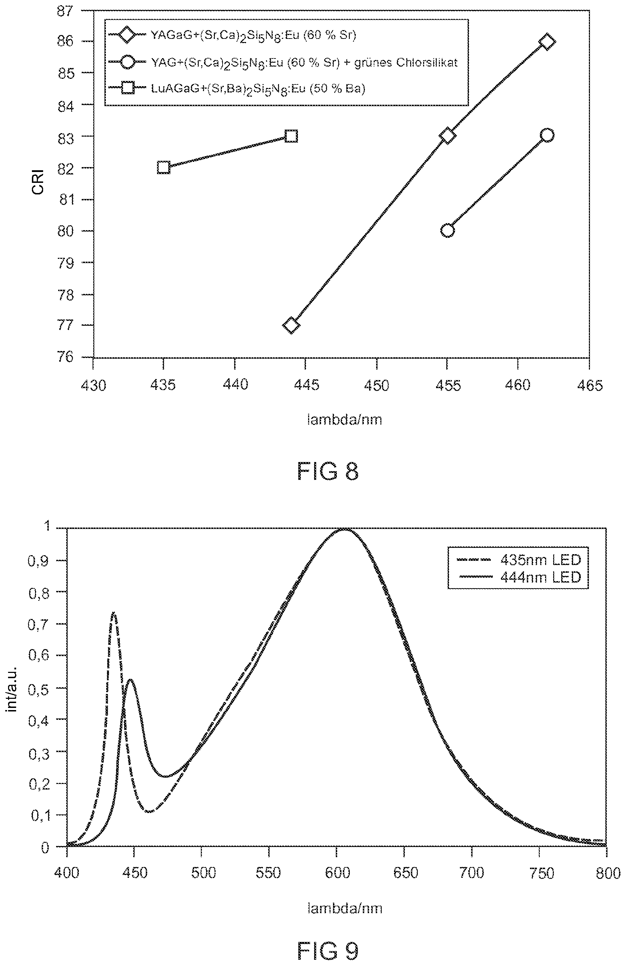

Figur 8 zeigt den Farbwiedergabeindex (CRI) Ra8 für verschiedene Systeme. Die Farbwiedergabe einer warmweißen LED mit der erfindungsgemäßen neuen Leuchtstoffmischung (Muster 1 und 2) ist praktisch unabhängig von der eingesetzten LED-Wellenlänge. Eine Verschiebung der Blau-Wellenlänge um 9 nm bewirkt nur einen CRI-Verlust von 1 Punkt (viereckige Messpunkte). Das Vergleichsbeispiel der bisherigen Mischung verliert bereits bei einem Unterschied von 7 nm Blau-Wellenlänge 5 Punkte (runde Messpunkte; siehe Tabelle, VGL 1 und VGL3). Um den CRI-Verlust auf 1 Punkt zu verringern, ist die Zugabe eines dritten Leuchtstoffs nötig (VGL2), was die Effizienz und das Colour-Steering negativ beeinflusst. Ein weiteres Vergleichsbeispiel (rautenförmige Messpunkte) bezieht sich auf YAG als gelb-grüner Komponente mit Sr-Ba-Nitridosilikat. Erstaunlicherweise ist dieses System drastisch schlechter als das verwandte erfindungsgemäße System und ähnlich schlecht wie die Drei-Leuchtstoff-Variante (VGL2).

Figur 9 erläutert die Ursache für die (nahezu perfekte) Unabhängigkeit des Farbwiedergabeindex CRI von der Blau-Wellenlänge: Die Leuchtstoff-Emission verschiebt sich beim erfindungsgemäßen System überraschend mit zunehmend kurzwelliger Anregungswellenlänge deutlich zu kurzen Wellenlängen hin. Dadurch ergibt sich eine gewisse Kompensation im Gesamtspektrum: Die fehlenden Blau-Grün-Anteile durch Einsatz einer kürzerwelligen LED werden durch die verstärkten Blau-Grün-Anteile der verschobenen Leuchtstoffemission gerade in etwa ausgeglichen.

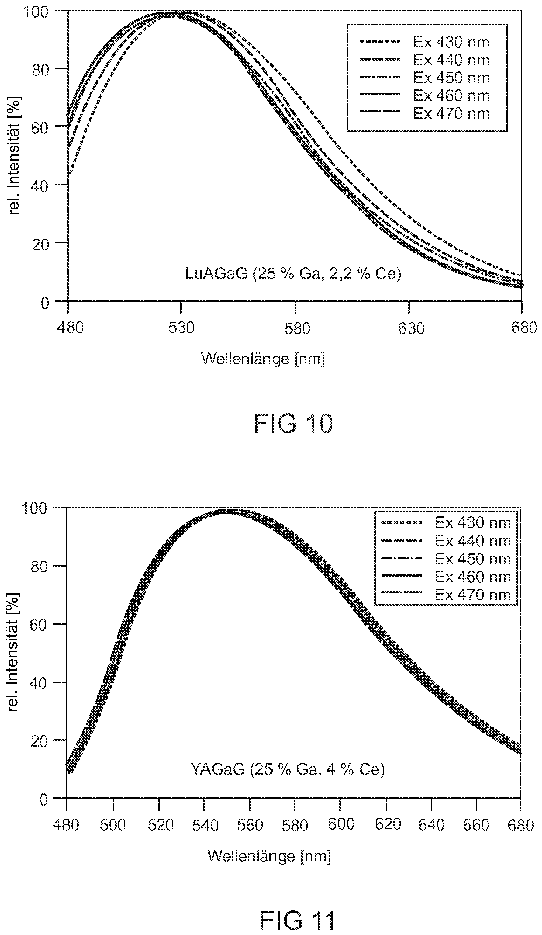

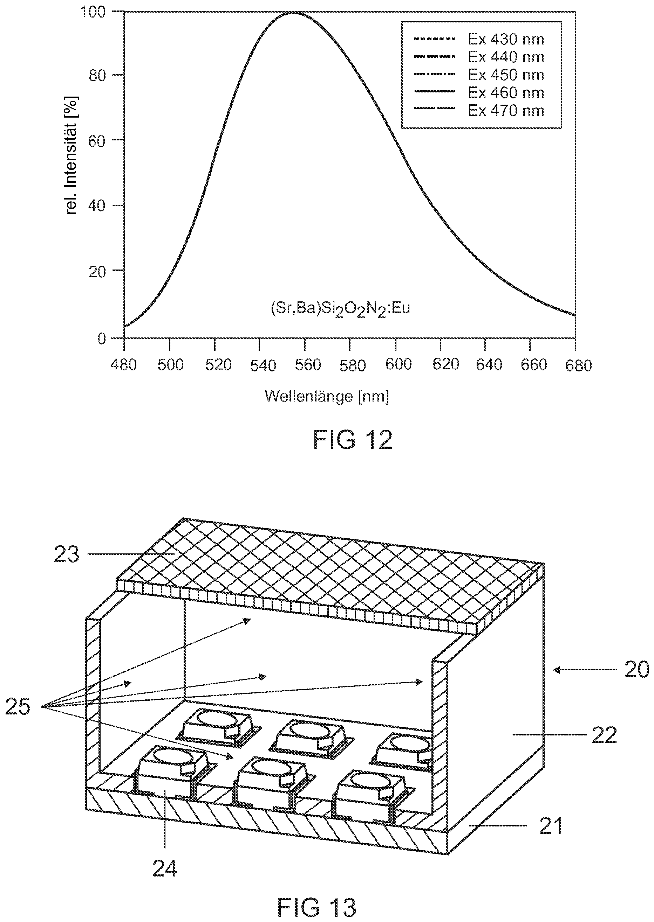

Figur 10 zeigt die relative Intensität bei einer Verschiebung des Leuchtstoffspektrums des Grün-gelb-Leuchtstoffs mit variabler Anregungswellenlänge zwischen 430 und 470 nm (Ex430 bis 470) im Vergleich zu YAGaG:Ce (Figur 11) und gelbem (Sr,Ba)Si2O2N2:Eu (Figur 12).

Überraschenderweise verhält sich der neue grüne LuAGaG-Granat deutlich anders als die Vergleichs-Leuchtstoffe. Er zeigt eine starke Grünverschiebung mit sinkender Anregungswellenlänge. Die Vergleichs-Leuchtstoffe bleiben etwa konstant. Gezeigt sind die Emissionsspektren der drei Leuchtstoffe im Vergleich im für LED-Anwendungen interessanten Blauwellenlängenbereich zwischen 430 und 470nm.

Die Kurven der Figur 12 liegen praktisch alle übereinander, so dass nur eine Kurve dargestellt ist.

Der Einsatz eines Lutetium-Granats, der allenfalls Y als Beimischung bis 30 Mol.-% enthält, wirkt sich - bedingt durch die geänderte Form des Emissionsspektrums - insgesamt deutlich positiv auf die Farbwiedergabe aus. Der Einsatz von Y-Granaten führt nicht zu derart hohen Werten der Farbwiedergabe, die mit Lu-Granat realisierbar sind. Details verschiedener Mischungen finden sich in Tab. 2. Gd ist als wesentliche Komponente völlig ungeeignet und sollte, ebenso wie Tb oder La, höchstens zur Feinabstimmung in kleinen Mengen bis 5 Mol.-% der Komponente A zugesetzt werden. Dagegen liefert ein Anteil Y bis etwa 30%, bevorzugt mit einem Anteil 10 bis 25%, eine gute Ergänzung zu Lu. Ursache ist der relativ ähnliche Ionenradius von Lu und Y. Höhere Werte von Y würden die Emission des Leuchtstoffs aber wieder in einen Bereich verschieben, der die gewünschte Performance des Gesamtsystems beeinträchtigen würde. Im Vergleich mit Yttrium-Granaten mit ähnlicher Leuchtstoff-Emissionswellenlänge (Muster VGL 1 bis VGL4), und überraschend sogar bei ähnlicher dominanter Leuchtstoff-Emissionswellenlänge (Muster VGL 3 und VGL4), ergeben sich bei den Mustern 1 bis 3 deutlich höhere Farbwiedergabewerte Ra8, siehe Tabelle 2. ergeben sich bei den Mustern 1 bis 3 deutlich höhere Farbwiedergabewerte Ra8, siehe Tabelle 2. Dadurch und durch die gute Anregbarkeit bei kurzen Wellenlängen können erstmals hocheffiziente, kurzwellige blaue LEDs für Konversions-LED eingesetzt werden.

**Tab. 2**

| Muster | Peak-Wellenlänge der blauen LED / nm | Farbtemperatur / K | Leuchtstoff 1 (grün-gelb) | Leuchtstoff 2 (orange-rot) | Verhältnis gelb:rot | Ra8 |
|---|---|---|---|---|---|---|
| | | | | | | |
| VGL1 | 455 | 3150 | YAG:2%Ce | Sr2Si5N8:Eu | 16:1 | 77 |
| VGL2 | 455 | 3200 | YAGaG:4%Ce (25%Ga) | Sr2Si5N8:Eu | 7:1 | 79 |
| 1 | 455 | 3200 | LuAG:4%Ce | Sr2Si5N8:Eu | 7.8:1 | 82 |
| | | | | | | |
| | | | | | | |
| VGL3 | 444 | 3000 | YAGaG:2%Ce (40%Ga) | (Sr,Ba)2Si5N8:Eu (87.5% Sr) | 10.6:1 | 85 |
| 2 | 444 | 3050 | LuAGaG:2.2%Ce (25%Ga) | (Sr,Ba)2Si5N8:Eu (87.5% Sr) | 12.4:1 | 89 |
| | | | | | | |
| | | | | | | |
| VGL4 | 435 | 3100 | YAGaG:2%Ce (40%Ga) | (Sr,Ba)2Si5N8:Eu (50% Ba) | 7:1 | 78 |
| 3 | 435 | 3100 | LuAGaG:2.2%Ce (25%Ga) | (Sr,Ba)2Si5N8:Eu (50% Ba) | 7:1 | 82 |

Grundsätzlich ist die Verwendung der Leuchtstoff-Mischung als Dispersion, als Dünnfilm etc. direkt auf der LED oder auch wie an sich bekannt, auf einem separaten, der LED vorgeschalteten Träger möglich. Figur 13 zeigt ein derartiges Modul 20 mit diversen LEDs 24 auf einer Grundplatte 21. Darüber ist ein Gehäuse montiert mit Seitenwänden 22 und einer Deckplatte 12. die Leuchtstoff-Mischung ist hier als Schicht 25 sowohl auf den Seitenwänden als auch vor allem auf der Deckplatte 23, die transparent ist, angebracht.

Die Bezeichnung Leuchtstoff des Typs Nitridosilikat M2Si5N8:Eu beinhaltet auch Modifikationen des einfachen Nitridosilikats, bei dem Si teilweise durch Al und/oder B ausgetauscht sein kann und wobei N teilweise durch O und/oder C ausgetauscht sein kann, so dass durch den Austausch Ladungsneutralität gewährleistet ist. Derartige modifizierte Nitridosilikate sind an sich bekannt, siehe dazu beispielsweise EP-A 2 058 382. Formal kann ein derartiges Nitridosilikat als M2X5Y8:D beschrieben werden, mit M=(Ba,Sr) und X=(Si,A,B) und Y=(N,O,C) sowie D=Eu allein oder mit einer Kodotierung.

Tab. 3 zeigt verschiedene Granate aus dem System A3B5O12:Ce mit A ausgewählt aus (Lu,Y). Dabei zeigt sich, dass für A=Lu bis hin zu A= 70%Lu, Rest Y gute Werte erzielt werden können. Gleichzeitig muss für Komponenten B das Verhältnis zwischen Al und Ga sorgfältig gewählt werden. Der Anteil Ga sollte zwischen 10 und 40 Mol.-%, insbesondere 10 bis 25% liegen. Dabei sind in Tab. 7 verschiedene (Lu,Y)-Granate A3B5O12:Ce gezeigt, wobei die Konzentration des Aktivators Ce jeweils 2% von A beträgt und A = Lu,Y (angegeben ist der Anteil des Lu, Rest ist Y) sowie B= Al,Ga (angegeben ist der Anteil Ga, Rest ist Al) gewählt ist. Reiner LuAG:Ce oder YAG:Ce ist ungeeignet. Ebenso ist die Zugabe von Pr für die Effizienz des Leuchtstoffs äußerst schädlich und sollte tunlichst vermeiden werden.

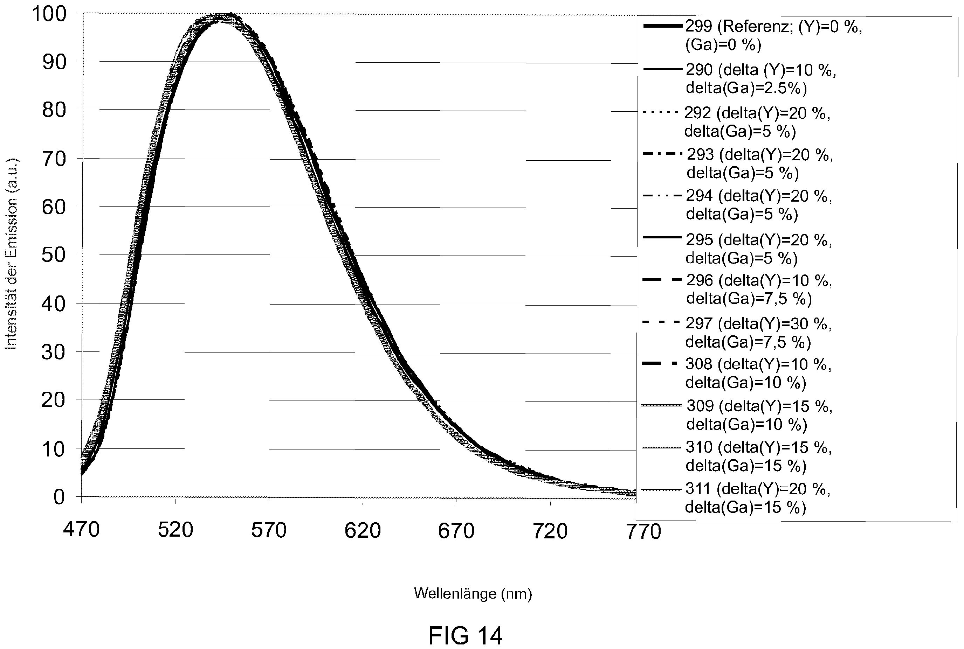

Figur 14 zeigt Emissionsspektren für verschiedene Granate, bei denen der Anteil des Y variiert wurde. Es zeigt sich, dass die Emission für kleine Anteil Y nahezu konstant bleibt.

Tab. 4 zeigt reine LuAGAG-Leuchtstoffe mit schrittweise erhöhtem Ga-Anteil. Diese Tabellenwerte, auch der anderen Tabellen, beziehen sich grundsätzlich immer auf eine Referenzanregung bei 460 nm.

**Tab. 4: Lu(Al, Ga)-Granate A3B5O12:Ce (sog. LuAGAG)**

| Probennummer | Anteil Lu, Rest Y | Anteil Ga, Rest Al | x | y | lambda _dom / nm | FWHM / nm | rel. QE |
|---|---|---|---|---|---|---|---|
| SL 315c/08 | 100% | 5,0% | 0,350 | 0,567 | 557,5 | 109,1 | 1,00 |
| SL 005c/09 | 100% | 15,0% | 0,337 | 0,572 | 555,1 | 104,3 | 1,01 |
| SL 003c/09 | 100% | 20,0% | 0,351 | 0,564 | 557,7 | 108,4 | 1,05 |
| SL 167c/08 | 100% | 25,0% | 0,352 | 0,562 | 557,9 | 109,8 | 1,05 |

**Tab. 3: (Lu,Y)-Granate A3B5O12:Ce**

| Probennummer | Anteil Lu, Rest Y | Anteil Ga, Rest Al | x | y | lambda_dom / nm | FWHM / nm | rel. QE |
|---|---|---|---|---|---|---|---|
| SL 299c/08 | 100% | 0,0% | 0,393 | 0,557 | 564,2 | 112,5 | 1,00 |
| SL 290c/08 | 88% | 2,5% | 0,396 | 0,556 | 564,6 | 113,2 | 1,02 |
| SL 291c/08 | 68% | 2,5% | 0,414 | 0,550 | 567,1 | 115,4 | 1,01 |
| SL 292c/08 | 78% | 5,0% | 0,400 | 0,555 | 565,2 | 113,7 | 1,01 |
| SL 293c/08 | 78% | 5,0% | 0,400 | 0,556 | 565,1 | 114,3 | 1,01 |
| SL 294c/08 | 78% | 5,0% | 0,401 | 0,555 | 565,3 | 114,8 | 1,02 |
| SL 295c/08 | 78% | 5,0% | 0,401 | 0,555 | 565,3 | 113,8 | 1,02 |
| SL 296c/08 | 88% | 7,5% | 0,388 | 0,559 | 563,5 | 112,8 | 1,02 |
| SL 297c/08 | 68% | 7,5% | 0,402 | 0,555 | 565,4 | 114,4 | 1,03 |
| SL 308c/08 | 88% | 10,0% | 0,383 | 0,560 | 562,8 | 112,1 | 1,03 |
| SL 309c/08 | 83% | 10,0% | 0,387 | 0,559 | 563,3 | 112,5 | 1,03 |
| SL 310c/08 | 83% | 15,0% | 0,381 | 0,560 | 562,5 | 113,0 | 1,03 |
| SL 311c/08 | 78% | 15,0% | 0,385 | 0,559 | 563,1 | 112,3 | 1,02 |

## Patentansprüche

1. Konversions-LED mit einem Chip, der primäre blaue Strahlung emittiert, sowie einer dem Chip vorgelagerten Leuchtstoff enthaltenden Schicht, die mindestens einen Teil der primären Strahlung des Chips in sekundäre Strahlung konvertiert, wobei ein erster gelb-grün emittierender Leuchtstoff des Typs Granat A3B5O12:Ce und ein zweiter orange-rot emittierender Leuchtstoff des Typs Nitridosilikat M2X5Y8:D verwendet wird, **dadurch gekennzeichnet, dass** die Peak-Wellenlänge der primären Strahlung im Bereich 430 bis 445 nm, liegt, während der erste Leuchtstoff ein Granat mit dem Kation A = Lu oder eine Mischung Lu,Y mit bis zu 30% Y-Anteil ist, und wobei B gleichzeitig Anteile von Al und Ga aufweist, **und wobei der erste Leuchtstoff 1,5 % bis 2,9 Mol.-% Ce bei der Komponente A enthält,** Rest ist A, während der zweite Leuchtstoff ein Nitridosilikat ist, das gleichzeitig Ba und Sr als Kation M enthält, und bei dem die Dotierung aus Eu besteht, wobei der zweite Leuchtstoff **35 bis 65 Mol.-% Ba** bei der Komponente M enthält, Rest ist Sr, wobei X=Si und Y=N gilt.

2. Konversions-LED nach Anspruch 1, **dadurch gekennzeichnet, dass** der erste Leuchtstoff bei der Komponente B 10%, bevorzugt 15%, bis 40 Mol.-% Ga, bevorzugt bis 35%, insbesondere 20 bis 30%, enthält, Rest ist Al.

3. Konversions-LED nach Anspruch 1, **dadurch gekennzeichnet, dass** der erste Leuchtstoff 1,8 bis 2,6 Mol.-% Ce, bei der Komponente A enthält, Rest ist A, insbesondere nur Lu oder Lu mit einem Anteil Y von bis zu 25 %.

4. Konversions-LED nach Anspruch 1, **dadurch gekennzeichnet, dass** der zweite Leuchtstoff 40 bis 60% Ba bei der Komponente M enthält, Rest ist Sr, wobei X=Si und Y=N gilt.

5. Konversions-LED nach Anspruch 1, **dadurch gekennzeichnet, dass** der zweite Leuchtstoff 1 bis 20 Mol.-% Eu, insbesondere 2 bis 6%, bei der Komponente M enthält, Rest ist (Ba,Sr).

6. Konversions-LED nach Anspruch 1, **dadurch gekennzeichnet, dass** der zweite Leuchtstoff (Sr0,48Ba0,48Eu0,04)2Si5N8 ist.

7. Konversions-LED nach Anspruch 6, **dadurch gekennzeichnet, dass** der erste Leuchtstoff A3B5O12 ist, mit A = 75 bis 100% Lu, Rest Y und einem Ce-Gehalt von 1,5 bis 2,5%, mit B = 10 bis 40 % Ga, Rest Al.

8. Konversions-LED nach Anspruch 7, **dadurch gekennzeichnet, dass** der erste Leuchtstoff A3B5O12 ist, mit A = 80 bis 100% Lu, Rest Y und einem Ce-Gehalt von 1,5 bis 2,5%, mit B = 15 bis 30 % Ga, Rest Al.

9. Konversions-LED nach Anspruch 8, **dadurch gekennzeichnet, dass** der erste Leuchtstoff (Lu0.978Ce0.022)3Al3.75Ga1.25O12 ist.

## Claims

1. A conversion LED with a chip which emits primary blue radiation, and a luminescent substance containing layer upstream from the chip which converts at least part of the primary radiation of the chip into secondary radiation, wherein a first yellow-green emitting luminescent substance of the garnet type A3B5O12:Ce and a second orange-red emitting luminescent substance of the type nitride silicate M2X5Y8:D is used, **characterized in that** the peak wavelength of the primary radiation is in the range of 430 to 445 nm, while the first luminescent substance is a garnet with the cation A = Lu or a mixture of Lu,Y with Y having a fraction of up to 30%, and wherein B contains fractions of both Ga and Al and wherein the first luminescent substance contains 1.5% to 2.9 mol% Ce in the component A, remainder is A, while the second luminescent substance is a nitride silicate which contains both Ba and Sr as cation M, and in which the doping consists of Eu, wherein the second luminescent substance contains 35 to 65 mol% Ba for the component M, remainder is Sr, where X = Si and Y = N.

2. The conversion LED according to claim 1, **characterized in that** in component B the first luminescent substance contains 10%, preferably 15%, up to 40 mol% Ga, preferably up to 35%, in particular 20 to 30%, remainder is Al.

3. The conversion LED according to claim 1, **characterized in that** the first luminescent substance contains 1.8% to 2.6 mol% Ce in the component A, remainder is A, in particular only Lu or Lu with a fraction Y of up to 25%.

4. The conversion LED according to claim 1, **characterized in that** the second luminescent substance contains 40 to 60% Ba in the component M, remainder is Sr, where X = Si and Y = N.

5. The conversion LED according to claim 1, **characterized in that** the second luminescent substance contains 1 to 20 mol% Eu, in particular 2 to 6%, in the component M, remainder is (Ba,Sr).

6. The conversion LED according claim 1, **characterized in that** the second luminescent substance is (Sr0.48Ba0.48Eu0.04)2Si5N8.

7. The conversion LED according to claim 6, **characterized in that** the first luminescent substance is A3B5O12, with A = 75 to 100% Lu, remainder Y and a Ce content of 1.5 to 2.5%, with B = 10 to 40% Ga, remainder Al.

8. The conversion LED according to claim 6, **characterized in that** the first luminescent substance is A3B5O12, with A = 80 to 100% Lu, remainder Y and a Ce content of 1.5 to 2.5%, with B = 15 to 30% Ga, remainder Al.

9. The conversion LED according to claim 8, **characterized in that** the first luminescent substance is (Lu0.978Ce0.022)3Al3.75Gal.25O12.

## Revendications

1. DEL à conversion comprenant une puce, qui émet un rayonnement primaire bleu, ainsi qu'une couche contenant une substance luminescente située devant la puce, qui convertit au moins une partie du rayonnement primaire de la puce en un rayonnement secondaire, une première substance luminescente émettant dans le jaune-vert de type grenat A3B5O12:Ce et une deuxième substance luminescente émettant dans l'orange-rouge de type nitridosilicate M2X5Y8:D étant utilisées, **caractérisée en ce que** la longueur d'onde maximale du rayonnement primaire se situe dans la plage allant de 430 à 445 nm, tandis que la première substance luminescente est un grenat avec le cation A = Lu ou un mélange Lu,Y avec une proportion de Y de jusqu'à 30 %, et B comprend simultanément des proportions de Al et de Ga, et la première substance luminescente contient 1,5 à 2,9 % en moles de Ce dans le composant A, le reste étant A, tandis que la deuxième substance luminescente est un nitridosilicate, qui contient simultanément Ba et Sr en tant que cation M, et dans lequel le dopage est constitué d'Eu, la deuxième substance luminescente contenant 35 à 65 % en moles de Ba dans le composant M, le reste étant Se, avec X = Si et Y = N.

2. DEL à conversion selon la revendication 1, **caractérisée en ce que** la première substance luminescente contient dans le composant B 10 %, de préférence 15 %, jusqu'à 40 % en moles de Ga, de préférence jusqu'à 35 %, notamment 20 à 30 %, le reste étant Al.

3. DEL à conversion selon la revendication 1, **caractérisée en ce que** la première substance luminescente contient 1,8 à 2,6 % en moles de Ce, dans le composant A, le reste étant A, notamment uniquement Lu ou Lu avec une proportion de Y de jusqu'à 25 %.

4. DEL à conversion selon la revendication 1, **caractérisée en ce que** la deuxième substance luminescente contient 40 à 60 % de Ba dans le composant M, le reste étant Sr, avec X = Si et Y = N.

5. DEL à conversion selon la revendication 1, **caractérisée en ce que** la deuxième substance luminescente contient 1 à 20 % en moles d'Eu, notamment 2 à 6 %, dans le composant M, le reste étant (Ba, Sr).

6. DEL à conversion selon la revendication 1, **caractérisée en ce que** la deuxième substance luminescente est (Sr0,48Ba0,48Eu0,04)2Si5N8.

7. DEL à conversion selon la revendication 6, **caractérisée en ce que** la première substance luminescente est A3B5O12, avec A = 75 à 100 % de Lu, le reste étant Y et une teneur en Ce de 1,5 à 2,5 %, avec B = 10 à 40 % de Ga, le reste étant Al.

8. DEL à conversion selon la revendication 7, **caractérisée en ce que** la première substance luminescente est A3B5O12, avec A = 80 à 100 % de Lu, le reste étant Y et une teneur en Ce de 1,5 à 2,5 %, avec B = 15 à 30 % de Ga, le reste étant Al.

9. DEL à conversion selon la revendication 8, **caractérisée en ce que** la première substance luminescente est (Lu0,978Ce0,022)3Al3,75Gal,25O12.
